# EUROPEAN PATENT APPLICATION

(11) **EP 4 403 928 A1**
(43) Date of publication of application: **24.07.2024**
(21) Application number: 24152328.1
(22) Date of filing: 17.01.2024
(51) Int. Cl.: G01R 15/20

(54) **CURRENT SENSOR WITH DIAGNOSTIC FEATURE**

(30) Priority: 17.01.2023 US 202363439442 P
(71) Applicant: Littelfuse, Inc., Chicago, IL 60631 (US)
(72) Inventor: Golubovic, Boris, Chicago, 60631 (US); Zatorre, Guillermo, Chicago, 60631 (US); Martinez, Cesar, Chicago, 60631 (US)
(74) Representative: Arnold & Siedsma

(57) **Abstract**

Provided herein are approaches for improving performance of current sensors. In some embodiments, an apparatus may include a current sensor coupled to a busbar, the current sensor comprising a coil, wherein a current flowing through the busbar generates a first magnetic field detectable by the current sensor, wherein the coil is operable to generate a second magnetic field, and wherein by orienting the coil, the current sensor will receive part of the second magnetic field, superposed to the first magnetic field.

## Description

### Field of the Disclosure

The disclosure relates generally to the field of circuit protection devices and, more particularly, to a current sensor with a diagnostic feature for in-situ feedback.

### Background of the Disclosure

Current sensors are often used in overcurrent protection devices, including in short-circuit protection devices. These devices are used as safety elements in critical applications, such as electric vehicles (EV). Oftentimes, current sensors are factory calibrated or compensated. However, prior art approaches lack effective in-situ solutions to periodically check if the current sensor is still operational and calibrated.

It is with respect to this and other deficiencies of the prior art that the current disclosure is provided.

### Summary of the Disclosure

The Summary is provided to introduce a selection of concepts in a simplified form, the concepts further described below in the Detailed Description. The Summary is not intended to identify key features or essential features of the claimed subject matter, nor is the Summary intended as an aid in determining the scope of the claimed subject matter.

In one approach according to the present disclosure, An apparatus may include a current sensor coupled to a busbar, the current sensor comprising a coil, wherein a current flowing through the busbar generates a first magnetic field detectable by the current sensor, wherein the coil is operable to generate a second magnetic field, and wherein by orienting the coil, the current sensor will receive part of the second magnetic field, superposed to the first magnetic field.

### Brief Description of the Drawings

The accompanying drawings illustrate exemplary approaches of the disclosed embodiments so far devised for the practical application of the principles thereof, and in which:
**FIG. 1** depicts a current sensor assembly according to embodiments of the present disclosure;
**FIG. 2** depicts a circuit diagram of the current sensor according to embodiments of the present disclosure;
**FIGs. 3-4** depict current and magnetic field of the current sensor as a function of time, according to embodiments of the present disclosure; and
**FIGs. 5-6** depict diagnostic flowcharts according to embodiments of the present disclosure.

The drawings are not necessarily to scale. The drawings are merely representations, not intended to portray specific parameters of the disclosure. The drawings are intended to depict typical embodiments of the disclosure, and therefore should not be considered as limiting in scope. In the drawings, like numbering represents like elements.

Furthermore, certain elements in some of the figures may be omitted, or illustrated not-to-scale, for illustrative clarity. Furthermore, for clarity, some reference numbers may be omitted in certain drawings.

### Detailed Description

Sensors, devices, and methods in accordance with the present disclosure will now be described more fully hereinafter with reference to the accompanying drawings. The sensors, devices, and methods may be embodied in many different forms and should not be construed as being limited to the embodiments set forth herein. Rather, these embodiments are provided so that this disclosure will be thorough and complete, and will fully convey the scope of the system and method to those skilled in the art.

As will be described herein, embodiments of the present disclosure provide for in-situ verification that a current sensor remains functional and retains calibration. The sensor status (i.e., working / not working) and loss of calibration may be reported to a superordinated control system, which can take appropriate action.

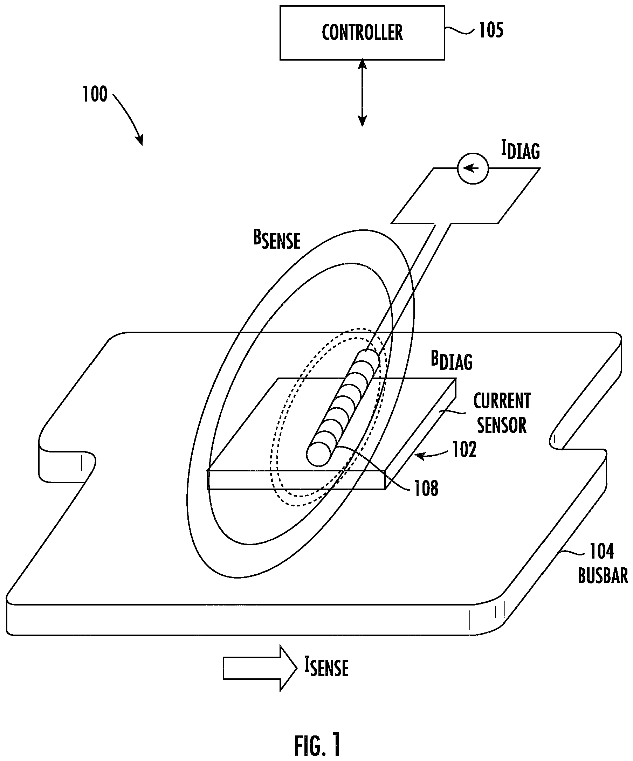

**FIG. 1** illustrates a current sensor assembly 100 (hereinafter "assembly") according to embodiments of the present disclosure. Although non-limiting, the assembly 100 may be used with a Hall or TMR sensor (not shown). The assembly 100 may include a current sensor 102 coupled to a busbar 104, the current sensor 102 including a coil 108 operable to generate a magnetic field *Bdiag.* The busbar 104 may be made of copper or other electrically conductive material. In an alternative embodiment, the current sensor 102 may be coupled to a PCB, wherein the main conductor of the assembly 100 may be a PCB trace, and the diagnostic coil could be build-up by traces on multiple layers of the PCB.

During use, the current *Isense* flowing through the busbar 104 generates a magnetic field *Bsense,* which is detected by the current sensor 102. A value representing the magnetic field may be delivered to a controller 105, which is operable with the current sensor 102. By properly orienting the coil 108, the current sensor 102 will receive part of this magnetic field, superposed to the *Bsense* magnetic field. As shown, the coil 108 may generally be oriented orthogonal/perpendicular to the direction of current *Isense* flowing through the busbar 104.

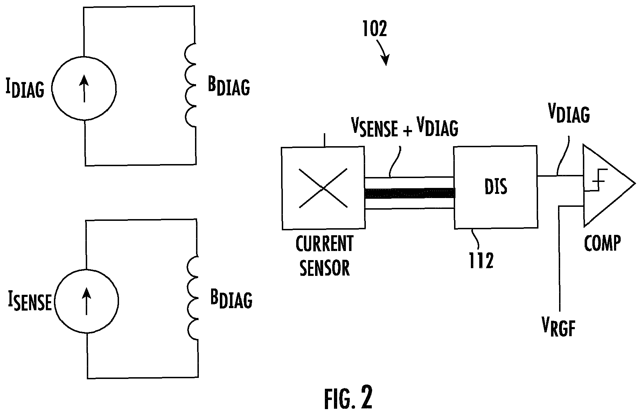

As shown in **FIG. 2****,** the current sensor 102, together with the controller 105, receives the sum of *Bsense* + *Bdiag,* and converts it to a voltage *Vsense* + *Vdiag.* In some embodiments, a discriminator (DIS) 112 removes *Vsense,* keeping *Viag* only. Given a certain invariable position of the coil 108 relative to the current sensor 102, and by setting an appropriate threshold level VREF, it is possible to determine if the current sensor 102 is operating properly by comparison.

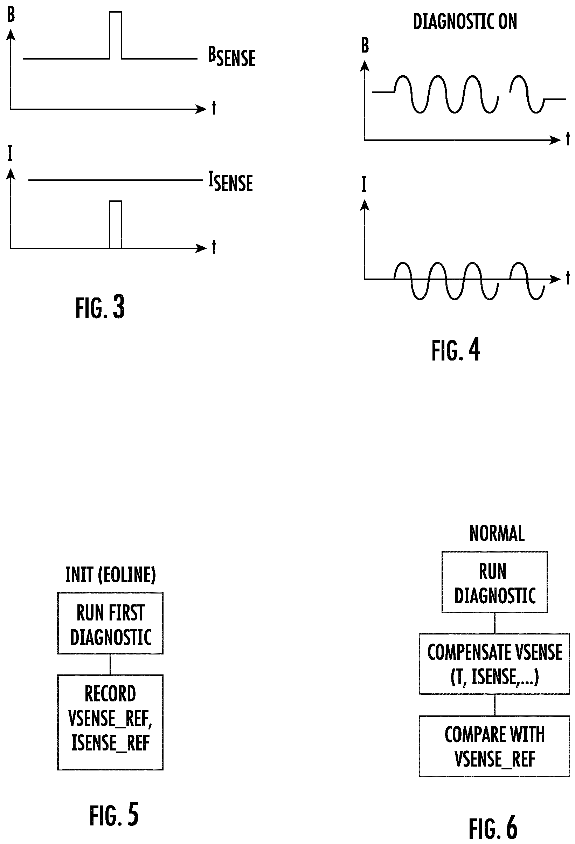

**FIG. 3** demonstrates the relationship between current (I) and magnetic field (B) over time. More specifically, the current *Idiag* can be a pulsed current, with a certain time duration. In this case, the DIS can separate *Vdiag* from *Vsense* because the time for Vsense is deterministic referenced to *Idiag.* Diagnostics can be run without sense current (e.g., vehicle parked, part of the initialization sequence) or with sense current (e.g., vehicle driving)

In **FIG. 4****,** the current *Idiag* can be a periodic current (i.e. sinusoidal), with a certain frequency. In this case, the DIS can separate *Vdiag* from *Vsense* because the frequency for Vsense is deterministic referenced to *Idiag.* Again, diagnostics can be run without sense current (e.g., vehicle parked, part of the initialization sequence) or with sense current (e.g., vehicle driving).

**FIGs. 5-6** demonstrate that the diagnostic may be run at the end of the manufacturing process ("Init (EoLine)"), once the relative position of the diagnostic coil referenced to the current sensor is fixed. Vsense_ref and Isense_ref are recorded. Every time the diagnostic is run in a normal mode, it is possible to check the calibration status by comparing the Vsense with the recorded value (e.g., after applying some corrections depending on other factors such as Isense, T, ...).

For the sake of convenience and clarity, terms such as "top," "bottom," "upper," "lower," "vertical," "horizontal," "lateral," and "longitudinal" will be used herein to describe the relative placement and orientation of components and their constituent parts as appearing in the figures. The terminology will include the words specifically mentioned, derivatives thereof, and words of similar import.

As used herein, an element or operation recited in the singular and proceeded with the word "a" or "an" is to be understood as including plural elements or operations, until such exclusion is explicitly recited. Furthermore, references to "one embodiment" of the present disclosure are not intended as limiting. Additional embodiments may also incorporating the recited features.

Furthermore, the terms "substantial" or "substantially," as well as the terms "approximate" or "approximately," can be used interchangeably in some embodiments, and can be described using any relative measures acceptable by one of ordinary skill in the art. For example, these terms can serve as a comparison to a reference parameter, to indicate a deviation capable of providing the intended function. Although non-limiting, the deviation from the reference parameter can be, for example, in an amount of less than 1%, less than 3%, less than 5%, less than 10%, less than 15%, less than 20%, and so on.

While certain embodiments of the disclosure have been described herein, the disclosure is not limited thereto, as the disclosure is as broad in scope as the art will allow and the specification may be read likewise. Therefore, the above description is not to be construed as limiting. Instead, the above description is merely as exemplifications of particular embodiments. Those skilled in the art will envision other modifications within the scope of the claims appended hereto.

## Claims

1. An apparatus, comprising:
a current sensor coupled to a busbar, the current sensor comprising a coil, wherein a current flowing through the busbar generates a first magnetic field detectable by the current sensor, wherein the coil is operable to generate a second magnetic field, and wherein by orienting the coil, the current sensor will receive part of the second magnetic field, superposed to the first magnetic field.

2. The apparatus of claim 1, wherein the coil is oriented perpendicular to a direction of the current flowing through the busbar.

3. The apparatus of claim 1, further comprising a controller operable with the current sensor, the controller operable to:
receive the sum of the first and second magnetic fields; and
convert the sum of the first and second magnetic fields to a voltage *Vsense + Vdiag,* wherein a discriminator removes *Vsense,* keeping *Viag* only.

4. The apparatus of claim 3, wherein the controller is further operable to determine if the sensor is operating properly given an invariable position of the coil relative to the current sensor, and a selected voltage threshold level.

5. A current sensing device, comprising:
a busbar; and
a current sensor coupled to the busbar, the current sensor comprising a coil, wherein a current flowing through the busbar generates a first magnetic field detectable by the current sensor, wherein the coil is operable to generate a second magnetic field, and wherein by orienting the coil, the current sensor will receive part of the second magnetic field, superposed to the first magnetic field.
